# EUROPEAN PATENT APPLICATION

(11) **EP 4 650 329 A1**
(43) Date of publication of application: **19.11.2025**
(21) Application number: 24763096.5
(22) Date of filing: 26.02.2024
(51) Int. Cl.: C03C 3/085, C03C 3/062, C03C 10/00, C03C 21/00

(54) **GLASS CERAMIC AND PREPARATION METHOD THEREFOR, GLASS COVER PLATE, AND ELECTRONIC DEVICE**

(30) Priority: 28.02.2023 CN 202310233344; 01.08.2023 CN 202310965149
(71) Applicant: Huawei Technologies Co., Ltd., Shenzhen, Guangdong 518129 (CN)
(72) Inventor: ZHU, Guangxiang, Shenzhen, Guangdong 518129 (CN); JIANG, WenJie, Shenzhen, Guangdong 518129 (CN); HUANG, Yihong, Shenzhen, Guangdong 518129 (CN); CHEN, Jiejie, Shenzhen, Guangdong 518129 (CN)
(74) Representative: Maiwald GmbH
(86) International application number: PCT/CN2024/078612
(87) International publication number: WO 2024/179414

(57) **Abstract**

Embodiments of this application provide glass-ceramic and a preparation method therefor, a glass cover, and an electronic device. Crystalline phases in the glass-ceramic are a spinel crystalline phase and a ZrO₂ crystalline phase. The glass-ceramic includes SiO₂, Al₂O₃, MgO, ZnO, ZrO₂, Na₂O, Li₂O with a molar percentage of 0% to 9%, and K₂O with a molar percentage of 0% to 5%; and molar percentages of components satisfy: 0.11≤(Li₂O+Na₂O+K₂O)/(SiO₂+Al₂O₃)≤0.30, and Na₂O/(MgO+ZnO)≤0.9. The glass-ceramic has good drop resistance and scratch resistance, and can better meet an application requirement in the field of electronic devices and the like.

## Description

This application claims priorities to Chinese Patent Application No. 202310233344.6, filed with the China National Intellectual Property Administration on February 28, 2023 and entitled "GLASS-CERAMIC", and to Chinese Patent Application No. 202310965149.2, filed with the China National Intellectual Property Administration on August 1, 2023 and entitled "GLASS-CERAMIC AND PREPARATION METHOD THEREFOR, GLASS COVER, AND ELECTRONIC DEVICE", both of which are incorporated herein by reference in their entireties.

### TECHNICAL FIELD

This application relates to the field of glass-ceramic preparation technologies, and specifically, to glass-ceramic and a preparation method therefor, a glass cover, and an electronic device.

### BACKGROUND

With popularization of electronic devices such as smartphones and tablet computers, a requirement for large-sized and ultra-thin touchscreen displays is increasingly prominent. This also imposes a higher requirement on mechanical properties of protective glass of the electronic devices, that is, both excellent drop resistance and good scratch resistance are required. Currently, protective glass widely used in the electronic devices is common aluminosilicate glass. The common aluminosilicate glass has low intrinsic structure strength, still has poor drop resistance even if a surface is chemically strengthened, and has low intrinsic hardness, and a large quantity of scratches are easily caused during use. This greatly affects use experience of consumers. Therefore, it is necessary to develop protective glass that is both drop-resistant and scratch-resistant, to better meet an application requirement of the electronic devices.

### SUMMARY

In view of this, embodiments of this application provide glass-ceramic. The glass-ceramic can have both good drop resistance and scratch resistance, and can better meet an application requirement in the field of electronic devices and the like.

Specifically, a first aspect of embodiments of this application provides glass-ceramic. Crystalline phases in the glass-ceramic are a spinel crystalline phase and a ZrO₂ crystalline phase. The glass-ceramic includes SiO₂, Al₂O₃, MgO, ZnO, ZrO₂, Na₂O, Li₂O with a molar percentage of 0% to 9%, and K₂O with a molar percentage of 0% to 5%; and molar percentages of the components in the glass-ceramic satisfy: 0.11≤(Li₂O+Na₂O+K₂O)/(SiO₂+Al₂O₃)≤0.30, and Na₂O/(MgO+ZnO)≤0.9.

In the glass-ceramic provided in embodiments of this application, the components and proportions of the components are properly adjusted, so that the crystalline phases precipitated from the glass-ceramic may be the spinel crystalline phase and the ZrO₂ crystalline phase. These crystalline phases can improve intrinsic structure strength and toughness of the glass. A ratio in molar percentages, that is, (Li₂O+Na₂O+K₂O)/(SiO₂+Al₂O₃) is controlled to range from 0.11 to 0.30, and Na₂O/(MgO+ZnO) is controlled to be less than or equal to 0.9, so that the glass-ceramic can have both excellent drop resistance and scratch resistance.

In some implementations of this application, 0.25≤Na₂O/(MgO+ZnO)≤0.9. This can ensure that the glass-ceramic has a high ion exchange capability, and can ensure that the glass-ceramic has an appropriate high-strength and high-hardness spinel crystalline phase, so that the glass-ceramic better has good drop resistance, scratch resistance, and the like.

In some implementations of this application, 0.11≤(Li₂O+Na₂O+K₂O)/(SiO₂+Al₂O₃)≤0.25. In this case, the glass-ceramic has better comprehensive performance.

In an implementation of this application, the glass-ceramic includes the following components in molar percentages:
SiO₂: 32% to 56%;
Al₂O₃: 15% to 35%;
MgO: 3% to 10%;
ZnO: 3% to 15%;
ZrO₂: 0.1% to 6%;
Na₂O: 0.1% to 12%;
Li₂O: 0% to 9%;
K₂O: 0% to 5%; and
B₂O₃: 0% to 10%.

In the glass-ceramic, when contents of the components in the molar percentages satisfy the foregoing relational expressions, the contents of the components are adjusted to be within the foregoing ranges, so that the glass-ceramic can have characteristics such as high transmittance, low coloring performance, high crystallinity, and a high Young's modulus, to better meet an application requirement in the field of electronic devices and the like.

In an implementation of this application, the spinel crystalline phase includes (MgₓZn₁₋ₓ)Al₂O₄, or includes MgAl₂O₄ and ZnAl₂O₄, or includes (MgₓZn₁₋ₓ)Al₂O₄, MgAl₂O₄, and ZnAl₂O₄, where 0<x<1. The spinel crystalline phase in the glass-ceramic in this application includes both an element Mg and an element Zn, and therefore has better drop resistance and scratch resistance than glass-ceramic including only Zn spinel or only magnesium spinel.

In an implementation of this application, a mass percentage of the spinel crystalline phase in the glass-ceramic is greater than that of the ZrO₂ crystalline phase. In other words, in the glass-ceramic, the spinel crystalline phase is used as a primary crystalline phase, and the ZrO₂ crystalline phase is used as a secondary crystalline phase.

In an implementation of this application, a sum of mass percentages of the spinel crystalline phase and the ZrO₂ crystalline phase in the 3D glass-ceramic is 5% to 90%. The glass-ceramic has proper crystallinity. This helps ensure that the glass-ceramic has excellent drop resistance, scratch resistance, light transmissivity, and the like.

In an implementation of this application, in the glass-ceramic, a ratio of the mass percentage of the spinel crystalline phase to the mass percentage of the ZrO₂ crystalline phase is (4 to 14):1. A ratio of crystallinity of the spinel crystalline phase to crystallinity of the ZrO₂ crystalline phase falls within this range, so that grains of the crystalline phases in the glass-ceramic are fine, and are evenly distributed, to ensure that the glass-ceramic has excellent mechanical strength and optical performance.

In an implementation of this application, both an average grain size of the spinel crystalline phase and an average grain size of the ZrO₂ crystalline phase are less than or equal to 60 nm. A smaller grain size helps improve transmittance of the glass-ceramic.

In an implementation of this application, when a thickness of the glass-ceramic is less than or equal to 0.7 mm, transmittance of the glass-ceramic to light with a wavelength of 550 nm is greater than or equal to 88%; a b value in Lab color space satisfies: |b value|≤2.0; and haze is less than or equal to 0.25%. These parameters may indicate that the glass-ceramic has good optical performance and can better meet optical requirements for displaying and photographing when being used in a display glass cover and a camera protection cover.

In an implementation of this application, a compression pressure layer is formed on a surface of the glass-ceramic, and there is a tensile stress layer inside the glass-ceramic. The glass-ceramic is chemically strengthened glass-ceramic.

In an implementation of this application, a depth of the compression pressure layer is greater than or equal to 80 µm. A larger depth of the compression pressure layer can enable the glass-ceramic to have higher drop resistance, thereby improving reliability of the electronic device.

In an implementation of this application, a compressive stress CS_50 of the glass-ceramic at a depth of 50 µm of the compression pressure layer is greater than or equal to 60 MPa. A higher CS_50 value can ensure that the glass-ceramic has higher strength.

In an implementation of this application, an absolute value |CT_AV| of an average tensile stress in the tensile stress layer is greater than or equal to 35 MPa. A larger average tensile stress can also indicate, to some extent, that the glass-ceramic has better compressive stress performance, higher strength, and better drop resistance.

In an implementation of this application, a Young's modulus of the glass-ceramic is greater than or equal to 95 GPa. In this embodiment of this application, the glass-ceramic has a high Young's modulus, and can better resist deformation.

In an implementation of this application, a Knoop scratch threshold for lateral cracking of the glass-ceramic is greater than or equal to 2 N. A higher Knoop scratch threshold for lateral cracking indicates better scratch resistance of the glass-ceramic provided in this embodiment of this application.

In this implementation of this application, a 180-mesh silicon carbide sandpaper ground drop resistance test is performed on the glass-ceramic with a thickness of 0.65 mm on an entire device with weight of 200 g; and an average drop-resistant height of the glass-ceramic obtained through the test is greater than or equal to 1.0 m. This can intuitively indicate excellent drop resistance of the glass-ceramic in this embodiment of this application.

A second aspect of embodiments of this application provides a preparation method for glass-ceramic, including:
mixing, according to proportions of components in the glass-ceramic, raw materials corresponding to the components in the glass-ceramic, and performing melting, molding, and annealing treatment to obtain a glass base material, where the components in the glass-ceramic include SiO₂, Al₂O₃, MgO, ZnO, ZrO₂, Na₂O, Li₂O with a molar percentage of 0% to 9%, and K₂O with a molar percentage of 0% to 5%; and molar percentages of the components in the glass-ceramic satisfy: 0.11≤(Li₂O+Na₂O+K₂O)/(SiO₂+Al₂O₃)≤0.30, and Na₂O/(MgO+ZnO)≤0.9;
sequentially performing nucleation treatment and crystallization treatment on the glass base material, so that the glass base material is crystallized to obtain a glass-ceramic material, where crystalline phases in the glass-ceramic are a spinel crystalline phase and a ZrO₂ crystalline phase; and
performing chemical strengthening treatment on the glass-ceramic to obtain the glass-ceramic.

The foregoing preparation method for the glass-ceramic has a simple process, and is suitable for industrial production. The glass-ceramic with both good drop resistance and scratch resistance can be prepared by using the preparation method.

An embodiment of this application further provides a glass cover. The glass cover is made of the glass-ceramic in the first aspect of embodiments of this application, or is made of the glass-ceramic prepared by using the preparation method for the glass-ceramic in the second aspect. The glass cover may be a display cover, a rear cover, a camera protection cover, or the like of an electronic device.

An embodiment of this application further provides an electronic device, including a housing assembled on an outer side of the electronic device and a circuit board located inside the housing. The housing is made of glass, and the glass includes the glass-ceramic in the first aspect of embodiments of this application, or the glass-ceramic prepared by using the preparation method for the glass-ceramic in the second aspect.

In some implementations of this application, the housing includes a display cover assembled on a front side of the electronic device, and the display cover includes the glass. In some other implementations of this application, the housing includes a rear cover assembled on a rear side of the electronic device, and the rear cover is made of the glass. In some other implementations of this application, the electronic device further includes a camera component located inside the housing, the housing includes a camera protection cover, the camera protection cover covers the camera component, and the camera protection cover is made of the glass. In an implementation of this application, the housing may be made partially of the foregoing glass, or may be made wholly of the foregoing glass. In the electronic device in this application, one or more of the display cover, the rear cover, and the camera protection cover may be made of the foregoing glass.

### BRIEF DESCRIPTION OF DRAWINGS

FIG. 1 is a diagram of a front-side structure of an electronic device according to an embodiment of this application;
FIG. 2 is a diagram of a rear-side structure of an electronic device according to an embodiment of this application;
FIG. 3 is a diagram of a structure of chemically strengthened glass-ceramic according to an embodiment of this application;
FIG. 4 is a diagram in which glass-ceramic in Comparative example 2 starts to generate a lateral crack in a Knoop scratch test; and
FIG. 5 is a diagram in which glass-ceramic in Comparative example 2 has lateral cracking scraps in a Knoop scratch test.

### DESCRIPTION OF EMBODIMENTS

The following describes embodiments of this application with reference to accompanying drawings in embodiments of this application.

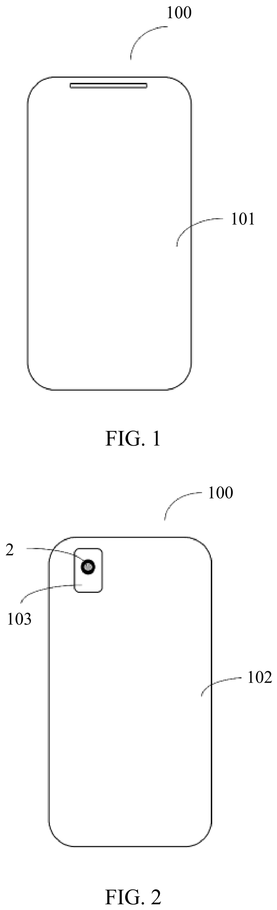

Refer to FIG. 1 and FIG. 2. An embodiment of this application provides an electronic device 100. The electronic device 100 may be a mobile phone, a tablet computer, a smart wearable device, or another electronic product. The electronic device 100 includes a housing assembled on an outer side of the electronic device and a circuit board located inside the housing. The housing includes a display cover 101 assembled on a front side of the electronic device 100 and a rear cover 102 assembled on a rear side of the electronic device 100. The display cover 101 covers a display module. The display cover 101 and/or the rear cover 102 are/is made of glass-ceramic provided in embodiments of this application. In this embodiment of this application, the display cover 101 may be made wholly of the glass-ceramic, or may be made only partially of the glass-ceramic. The rear cover 102 may be made wholly of the glass-ceramic, or may be made only partially of the glass-ceramic. In an implementation of this application, a display may be a touch display, and the display cover 101 may be a protection cover disposed on the touch display. In an implementation of this application, the rear cover 102 may cover only the rear side (a side away from the display) of the electronic device 100, or may cover both the rear side and a side frame of the electronic device 100. Optionally, the rear cover 102 may cover all side frames around the electronic device, or may cover a part of the side frames.

In some implementations of this application, as shown in FIG. 2, the electronic device 100 further includes a camera component 2 located inside the housing. The housing may include a camera protection cover 103. The camera protection cover 103 covers the camera component 2, and is configured to protect the camera component 2. The camera protection cover 103 is made of the glass-ceramic. In an implementation of this application, the camera protection cover 103 may be made partially of the glass-ceramic, or may be made wholly of the glass-ceramic. In an implementation of this application, a disposing position of the camera protection cover 103 is determined based on a disposing position of the camera component 2; and may be located on the front side of the electronic device 100, or may be located on the rear side of the electronic device 100. In some implementations of this application, the camera protection cover 103 and the display cover 101 or the rear cover 102 may be of a separated structure. In some other implementations of this application, the camera protection cover 103 and the display cover 101 or the rear cover 102 may alternatively be of an integrated structure.

Currently, various types of protective glass used in the electronic device 100, for example, glass used in the display cover 101, the rear cover 102, and the camera protection cover 103, are still mainly aluminosilicate glass. The aluminosilicate glass has low intrinsic structure strength, and still has poor drop resistance even if a surface is chemically strengthened. As a result, a screen breakage rate remains high. In addition, the aluminosilicate glass has low intrinsic hardness, and a large quantity of scratches are easily generated in use. This greatly affects use experience of consumers. Compared with the commonly used aluminosilicate glass, the glass-ceramic has better mechanical properties and attracts wide attention in the industry. However, it is difficult for the existing glass-ceramic to have both good drop resistance and good scratch resistance. In view of this, embodiments of this application provide glass-ceramic. The glass-ceramic has both good drop resistance and scratch resistance. The glass-ceramic can be used to manufacture various types of protective glass in the electronic device 100. Specifically, any one, any two, or all of the display cover 101, the rear cover 102, and the camera protection cover 103 in the electronic device 100 may use the glass-ceramic provided in embodiments of this application, to better meet optical requirements for displaying, photographing, and the like of the electronic device. In addition, this improves product reliability of the electronic device.

In an implementation of this application, a thickness of the glass-ceramic used in the display cover 101, the rear cover 102, and the camera protection cover 103 may be 0.4 mm to 2 mm. In some implementations of this application, the thickness of the glass-ceramic may alternatively be 0.5 mm to 1 mm, 0.6 mm to 1 mm, 0.6 mm to 0.8 mm, or the like. The glass-ceramic may be molded into a 2D or 2.5D planar product, or may be molded into a 3D curved product.

Specifically, crystalline phases in the glass-ceramic provided in embodiments of this application are a spinel crystalline phase and a ZrO₂ crystalline phase. The glass-ceramic includes SiO₂, Al₂O₃, MgO, ZnO, ZrO₂, Na₂O, Li₂O with a molar percentage of 0% to 9%, and K₂O with a molar percentage of 0% to 5%; and molar percentages of the components in the glass-ceramic satisfy: 0.11≤(Li₂O+Na₂O+K₂O)/(SiO₂+Al₂O₃)≤0.30, and Na₂O/(MgO+ZnO)≤0.9.

In the glass-ceramic provided in embodiments of this application, components and proportions of the components are properly adjusted, so that the crystalline phases precipitated from the glass-ceramic may be the spinel crystalline phase and the ZrO₂ crystalline phase. The spinel crystalline phase has a strong ionic bond, and has high hardness and a high Young's modulus. Existence of the spinel crystalline phase can improve hardness and scratch resistance of the glass-ceramic. The ZrO₂ crystalline phase can promote nucleation in formation of the spinel crystalline phase, and can refine grains. In addition, the two crystalline phases can prevent crack propagation in the glass-ceramic, improve cracking resistance of the glass, and improve drop resistance. In addition, a ratio of molar percentages of Na₂O and optional Li₂O and K₂O in the glass-ceramic to molar percentages of oxides SiO₂ and Al₂O₃ that form a glass network structure is controlled to satisfy: 0.11≤(Li₂O+Na₂O+K₂O)/(SiO₂+Al₂O₃)≤0.30, so that efficient ion exchange can be performed on the glass-ceramic, to further enhance strength of the glass-ceramic, and further improve drop resistance and scratch resistance, without excessively affecting the network structure and optical transmissivity of the glass-ceramic. In addition, the glass-ceramic can better balance good drop resistance and scratch resistance by controlling Na₂O/(MgO+ZnO)≤0.9. In this way, the glass-ceramic provided in embodiments of this application can have good drop resistance, good scratch resistance, and high transmissivity, to better meet an application requirement of protective glass materials in the field of electronic devices and the like.

In this application, Li₂O, Na₂O, and K₂O are network modifier oxides in the glass, and may disrupt the network structure of the glass, to improve viscosity of the glass. In addition, Li₂O and Na₂O are main components participating in ion exchange, contents of Li₂O and Na₂O affect stress performance of the strengthened glass, and Li₂O also affects precipitation of the spinel crystal, to affect transmissivity and the like of the glass. Therefore, (Li₂O+Na₂O+K₂O)/(SiO₂+Al₂O₃) is controlled to range from 0.11 to 0.30, to ensure that the glass-ceramic has a sufficiently high ion exchange capability, so that better strengthening effect is obtained without excessively affecting the network structure and light transmissivity of the glass. Specifically, (Li₂O+Na₂O+K₂O)/(SiO₂+Al₂O₃) may be specifically 0.11, 0.12, 0.13, 0.14, 0.15, 0.16, 0.17, 0.18, 0.19, 0.20, 0.21, 0.22, 0.23, 0.24, 0.25, 0.26, 0.27, 0.28, 0.29, 0.30, or the like. In some implementations, (Li₂O+Na₂O+K₂O)/(SiO₂+Al₂O₃) ranges from 0.11 to 0.25. In this case, the glass-ceramic has better comprehensive performance. In some embodiments, the ratio is 0.14 to 0.25. In some other implementations of this application, (Li₂O+Na₂O+K₂O)/(SiO₂+Al₂O₃) ranges from 0.14 to 0.30.

In this application, the foregoing term "ion exchange" is usually referred to as "chemical strengthening". A main principle is to exchange ions with a larger radius (such as K⁺ and Na⁺) in a molten salt with ions with a smaller radius (such as Na⁺ and Li⁺) in the glass, to form a compression pressure layer (namely, an ion exchange layer) with a specific depth on a surface of the glass through "congestion effect".

In an implementation of this application, the spinel crystalline phase includes (MgₓZn₁₋ₓ)Al₂O₄ (namely, magnesium-zinc spinel), or includes MgAl₂O₄ (namely, magnesium spinel) and ZnAl₂O₄ (namely, zinc spinel), or includes (MgₓZn₁₋ₓ)Al₂O₄, MgAl₂O₄, and ZnAl₂O₄, where 0<x<1. In some implementations, the spinel crystalline phase is (MgₓZn₁₋ₓ)Al₂O₄, MgAl₂O₄, and ZnAl₂O₄. The spinel crystalline phase in the glass-ceramic in this application includes both an element Mg and an element Zn, and therefore has better drop resistance and scratch resistance than glass-ceramic including only Zn spinel or only magnesium spinel.

In some implementations of this application, molar percentages of components in the glass-ceramic further satisfy: 0.25≤Na₂O/(MgO+ZnO)≤0.9. MgO and ZnO are necessary raw materials for forming the foregoing spinel crystalline phase, Na₂O is a main ion participating in ion exchange of the glass-ceramic, and a ratio of the molar percentage of Na₂O in the glass-ceramic and the sum of the molar percentages of MgO and ZnO in the glass-ceramic is controlled to range from 0.25 to 0.9. This helps ensure that the glass-ceramic has a high ion exchange capability, and ensure formation of an appropriate high-strength and high-hardness spinel crystalline phase. In this way, the glass better has both good drop resistance and scratch resistance. Specifically, Na₂O/(MgO+ZnO) may be specifically 0.3, 0.35, 0.40, 0.41, 0.42, 0.43, 0.44, 0.46, 0.47, 0.48, 0.49, 0.50, 0.52, 0.55, 0.60, 0.62, 0.65, 0.70, 0.75, 0.80, 0.82, 0.85, 0.89, or the like. In some implementations of this application, Na₂O/(MgO+ZnO) ranges from 0.46 to 0.90, and may further range from 0.46 to 0.80.

In an implementation of this application, the glass-ceramic includes the following components in molar percentages:
SiO₂: 32% to 56%;
Al₂O₃: 15% to 35%;
MgO: 3% to 10%;
ZnO: 3% to 15%;
ZrO₂: 0.1% to 6%;
Na₂O: 0.1% to 12%;
Li₂O: 0% to 9%;
K₂O: 0% to 5%; and
B₂O₃: 0% to 10%.

In the glass-ceramic in this application, when contents of the components in the molar percentages satisfy the foregoing relational expressions, the contents of the components are adjusted to be within the foregoing ranges, so that the glass-ceramic can have characteristics such as high transmittance, low coloring performance, high crystallinity, and a high Young's modulus, to better meet an application requirement in the field of electronic devices and the like.

SiO₂ (silicon dioxide) is a main oxide that forms the glass network structure, and can provide network structure strength for the glass. A higher content of SiO₂ indicates better connectivity of the glass network structure, higher glass density, and stronger mechanical performance. However, pure SiO₂ glass has a high melting point, and excessive SiO₂ makes the glass difficult to melt. Therefore, in this embodiment of this application, the molar percentage of SiO₂ is controlled to range from 32% to 56%, to ensure both good strength and good forming effect of the glass network structure. The molar percentage of SiO₂ may be specifically 33%, 35%, 36%, 40%, 41%, 42%, 45%, 48%, 50%, 52%, 53%, 54%, 55%, or the like. In some embodiments of this application, the molar percentage of SiO₂ may be 32% to 54%. In some other embodiments of this application, the molar percentage of SiO₂ is 36% to 56%, and is further 36% to 54%, 40% to 54%, or the like.

Al₂O₃ is a glass network former oxide, and may participate in the network structure of the glass in a form of an [AlO₄] tetrahedron. Increasing the content of Al₂O₃ can improve structure strength of the glass. In addition, a volume of the [AlO₄] tetrahedron is greater than that of [SiO₄]. This can provide a channel for movement of exchanged ions in a chemical strengthening procedure, thereby helping improve an ion exchange capability of the glass. In addition, Al₂O₃ is a component required for forming the spinel crystalline phase. Increasing the content of Al₂O₃ helps form more spinel crystals. However, excessive Al₂O₃ increases viscosity of a glass melt. Therefore, in this embodiment of this application, after comprehensive consideration, the content of Al₂O₃ in the glass-ceramic is controlled to range from 15 mol% to 35 mol%. Specifically, the molar percentage of Al₂O₃ may be 16%, 18%, 20%, 21%, 22%, 23%, 24%, 25%, 26%, 27%, 28%, 29%, 30%, 32%, 33%, 34%, 35%, or the like. In some embodiments of this application, the molar percentage of Al₂O₃ is 15% to 30%. In some other embodiments of this application, the molar percentage of Al₂O₃ may be 20% to 29%.

MgO and ZnO are necessary components for forming the foregoing spinel crystalline phase, are also intermediate oxides of the glass, and therefore can improve melting performance of the glass and reduce the viscosity of the glass melt. However, excessive MgO and ZnO affect chemical strengthening performance of the glass and reduce an ion exchange speed, and excessive ZnO also causes phase separation, devitrification, and the like of the glass. Therefore, through comprehensive consideration of the foregoing impact, in this embodiment of this application, the content of MgO in the glass-ceramic is controlled to range from 3 mol% to 10 mol%, and the content of ZnO is controlled to range from 3 mol% to 15 mol%. Specifically, the molar percentage of MgO may be 4%, 4.5%, 5%, 5.5%, 6%, 6.5%, 7%, 8%, 9%, 9.5%, 10%, or the like. In some embodiments of this application, the molar percentage of MgO is 3% to 8%, and may further be 3% to 7%, 5% to 6%, or the like. The molar percentage of ZnO may be 4%, 5%, 6%, 7%, 8%, 9%, 10%, 11%, 12%, 13%, 14%, 14.5%, or the like. In some embodiments of this application, the molar percentage of ZnO is 8% to 15%, and may further be 8% to 10%.

ZrO₂ is a nucleating agent in the glass-ceramic, and therefore helps prompt crystal precipitation, especially formation of the foregoing spinel crystalline phase in a crystallization procedure of forming the glass-ceramic, and can refine grains to improve transmittance of the glass-ceramic. However, excessive ZrO₂ increases difficulty in melting glass raw materials and makes formation difficult. Therefore, the molar percentage of ZrO₂ in this embodiment of this application is controlled to range from 0.1% to 6%. Specifically, the molar percentage of ZrO₂ may be 0.2%, 0.5%, 1%, 1.5%, 2.0%, 2.5%, 3%, 3.5%, 4%, 5%, 5.5%, or the like. In some embodiments, the molar percentage of ZrO₂ is 1% to 4%.

Li₂O and Na₂O are network modifier oxides in the glass, and may disrupt the network structure of the glass, to improve the viscosity of the glass. In addition, Li₂O and Na₂O are main components participating in ion exchange when the glass-ceramic is strengthened. A higher content may enable the glass-ceramic to obtain good stress performance through ion exchange. However, excessive Li₂O or Na₂O affects intrinsic strength of the glass, and excessive Li₂O further affects precipitation of the spinel crystal, resulting in a decrease in glass transmittance, even devitrification, and the like. Through consideration of the foregoing impact, in this embodiment of this application, the molar percentage of Na₂O in the glass-ceramic is controlled to range from 0.1% to 12%, and the molar percentage of Li₂O in the glass-ceramic is controlled to range from 0% to 9%. Specifically, in some embodiments, the molar percentage of Na₂O ranges from 0.1% to 10%, and may further range from 1 to 10%, for example, is specifically 1%, 1.5%, 2.0%, 2.5%, 3%, 3.5%, 4%, 5%, 5.5%, 6%, 6.5%, 7%, 7.5%, 8%, 8.5%, 9%, or 9.5%. In some other embodiments, the molar percentage of Na₂O is 5% to 9%. In this case, this better helps ensure that the glass-ceramic has better chemical strengthening performance after ion exchange, and has better scratch resistance. Specifically, in some embodiments, the molar percentage of Li₂O ranges from 0% to 8%, for example, is specifically 0.1%, 0.2%, 0.5%, 1%, 2%, 3%, 4%, 5%, 6%, 6.5%, 7%, 7.5%, or 8%. In some other embodiments, the molar percentage of Li₂O ranges from 0% to 7%.

Similar to Na₂O and Li₂O, K₂O can also reduce a melting temperature of the glass, and is conducive to melting and glass forming. However, an excessively high content of K₂O greatly reduces the ion exchange speed of the glass-ceramic, and affects glass strength and the like. Through consideration of the foregoing impact, in this embodiment of this application, the molar percentage of K₂O in the glass-ceramic is controlled to range from 0% to 5%. Specifically, the molar percentage of K₂O may be 0.1%, 0.2%, 0.3%, 0.5%, 0.8%, 1%, 1.5%, 2.0%, 2.5%, 3%, 3.5%, 4%, 4.5%, 5%, or the like. In some embodiments, the molar percentage of K₂O ranges from 0% to 3%.

B₂O₃ is a flux in a glass formation procedure, and therefore can improve the viscosity of the glass and reduce melting viscosity of the glass. However, excessive B₂O₃ affects mechanical strength of the glass. Through consideration of the foregoing impact, in this embodiment of this application, the molar percentage of B₂O₃ in the glass-ceramic is controlled to range from 0 to 10%, for example, is specifically 0.1%, 0.2%, 0.5%, 0.8%, 1%, 1.5%, 2.0%, 2.5%, 3%, 3.5%, 4%, 4.5%, 5%, 5.5%, 6%, 6.5%, 7%, 7.5%, 8%, 8.5%, 9%, or 9.5%.

In this application, the glass-ceramic includes a crystalline phase and a glass phase, and the crystalline phase is the spinel crystalline phase and the ZrO₂ crystalline phase. The spinel crystalline phase is a primary crystalline phase, and the ZrO₂ crystalline phase is a secondary crystalline phase. In other words, a mass percentage of the spinel crystalline phase in the glass-ceramic is greater than a mass percentage of the ZrO₂ crystalline phase in the glass-ceramic, that is, crystallinity of the spinel crystalline phase is greater than that of the ZrO₂ crystalline phase. The spinel crystalline phase is used as the primary crystalline phase, and the ZrO₂ crystalline phase is used as the secondary crystalline phase. These crystalline phases may be evenly distributed inside the glass-ceramic, and form a dense structure together with the glass phase. In this way, the glass-ceramic can obtain high hardness and a high Young's modulus, thereby ensuring good drop resistance and scratch resistance of the glass-ceramic; and can obtain good optical performance. In an implementation of this application, the crystalline phase in the glass-ceramic includes no spodumene or β-quartz solid solution.

In an implementation of this application, a sum of the mass percentages of the spinel crystalline phase and the ZrO₂ crystalline phase in the glass-ceramic (namely, a sum of crystallinity of the spinel crystalline phase and the ZrO₂ crystalline phase) is 5% to 90%. In other words, a total mass content of the crystalline phase in the glass-ceramic is 5% to 90%. Specifically, the value may be 5%, 10%, 15%, 20%, 25%, 30%, 35%, 40%, 45%, 48%, 50%, 55%, 60%, 65%, 70%, 75%, 80%, 85%, or the like. The hardness and the Young's modulus of the glass-ceramic can be adjusted by adjusting the sum of the crystallinity of the spinel crystalline phase and the ZrO₂ crystalline phase, so that the glass-ceramic has excellent drop resistance, scratch resistance, and the like. In some implementations, the sum of the mass percentages of the spinel crystalline phase and the ZrO₂ crystalline phase in the glass-ceramic is 10% to 50%, and may further be 20% to 50% or 28 to 46%. The content of the crystalline phase may be detected by using an X-ray diffraction (X-ray diffraction, XRD) method.

In an implementation of this application, in the glass-ceramic, a ratio of the mass percentage of the spinel crystalline phase to the mass percentage of the ZrO₂ crystalline phase is (4 to 14):1. A ratio of the crystallinity of the primary spinel crystalline phase to the crystallinity of the secondary ZrO₂ crystalline phase is controlled within this range. This can help better precipitate a crystalline phase with fine grains and even distribution from the glass-ceramic, to ensure excellent mechanical strength and optical performance, so as to better balance excellent drop resistance, scratch resistance, and light transmissivity. The mass percentages of the spinel crystalline phase and the ZrO₂ crystalline phase in the glass-ceramic may be calculated based on an XRD pattern of the glass-ceramic. Specifically, the ratio of the mass percentage of the spinel crystalline phase to the mass percentage of the ZrO₂ crystalline phase may be 4, 5, 6, 6.5, 7, 7.5, 8, 8.5, 9, 9.5, 10, 10.5, 11, 11.5, 12, 12.5, 13, 13.5, 14, or the like. In some implementations, the ratio may be 6 to 13.

In an implementation of this application, both an average grain size of the spinel crystalline phase and an average grain size of the ZrO₂ crystalline phase are less than or equal to 60 nm. Each of the spinel crystalline phase and the ZrO₂ crystalline phase has a small grain size, and the grain size is far less than a wavelength of visible light. This helps improve visible light transmittance of the glass-ceramic. In some implementations, both the average grain size of the spinel crystalline phase and the average grain size of the ZrO₂ crystalline phase are less than or equal to 50 nm, less than or equal to 45 nm, less than or equal to 42 nm, even less than or equal to 40 nm, or the like.

In an implementation of this application, a Young's modulus of the glass-ceramic is greater than or equal to 95 GPa. The Young's modulus is a physical quantity for describing a deformation resistance capability of a solid material. A larger Young's modulus indicates that the solid material is less likely to deform under an external force. In this embodiment of this application, the glass-ceramic has a high Young's modulus, and can better resist deformation. This helps improve drop resistance of the electronic device when the glass-ceramic is used in the electronic device. In some embodiments, the Young's modulus of the glass-ceramic may be greater than or equal to 96 GPa, greater than or equal to 97 GPa, greater than or equal to 98 GPa, greater than or equal to 99 GPa, greater than or equal to 100 GPa, or even greater than or equal to 105 GPa.

In an implementation of this application, the glass-ceramic still has excellent optical performance when having the foregoing crystalline phase characteristics and mechanical properties. Specifically, when a thickness of the glass-ceramic whose thickness is less than or equal to 0.7 mm is less than or equal to 0.7 mm, transmittance of the glass-ceramic to light with a wavelength of 550 nm is greater than or equal to 88%. In some embodiments, the transmittance is greater than or equal to 89%, or even greater than or equal to 90%. 550 nm is a typical wavelength of a visible light region, and the transmittance to the 550 nm light is high. This may indicate that the glass-ceramic in this embodiment of this application has a high visible light transmittance and can better meet optical requirements for displaying and photographing when being used in a display glass cover and a camera protection cover.

In this implementation of this application, a b value in Lab color space of the glass-ceramic whose thickness is less than or equal to 0.7 mm satisfies: |b value|≤2.0. The b value in Lab color space ranges from -2.0 to 2.0. This may indicate that the glass-ceramic in this embodiment of this application has low coloring performance and does not turn yellow or blue. This helps ensure high transmittance of the glass-ceramic. In some implementations, the |b value| is less than or equal to 1.0, and further is less than or equal to 0.9, less than or equal to 0.8, less than or equal to 0.75, or the like.

In an implementation of this application, haze of the glass-ceramic whose thickness is less than or equal to 0.7 mm is less than or equal to 0.25%. Low haze may also indicate that the glass-ceramic in this embodiment has high transmittance, does not have a "sandblasting" phenomenon, and can better meet the optical requirements for displaying and photographing when being used in the display glass cover and the camera protection cover. In some implementations, the haze is less than or equal to 0.22%, less than or equal to 0.20%, even less than or equal to 0.18%, less than or equal to 0.15%, or the like.

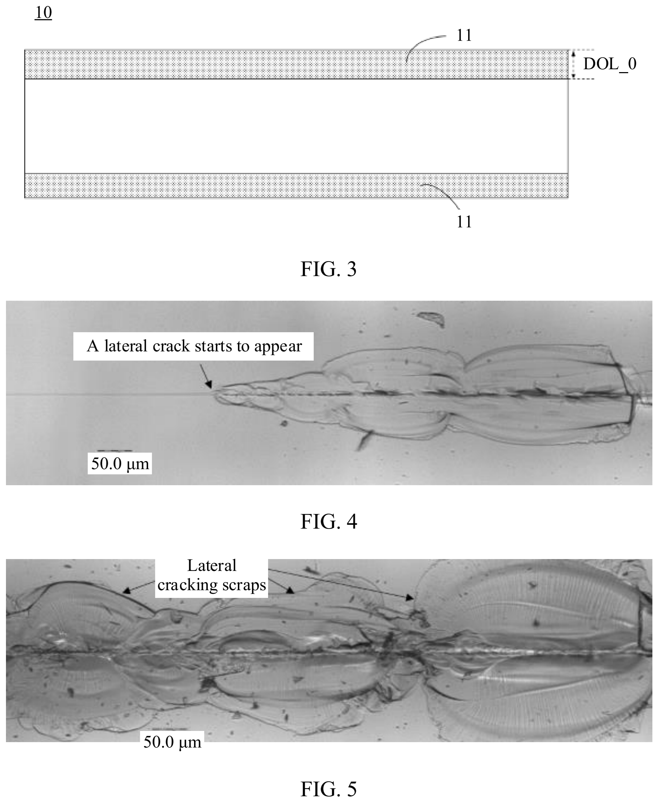

In an implementation of this application, a compression pressure layer is formed on a surface of the glass-ceramic, and there is a tensile stress layer inside the glass-ceramic. In other words, the glass-ceramic may be glass-ceramic obtained after ion exchange, namely, chemically strengthened glass-ceramic. For a main principle of "chemical strengthening", refer to the foregoing descriptions in this application. The compression pressure layer may also be referred to as a "strengthened layer". When the compression pressure layer is formed, the tensile stress layer is formed inside the glass. A compressive stress in the compression pressure layer may be represented as a positive stress, and correspondingly, a tensile stress that balances the compressive stress needs to be represented as a negative stress. FIG. 3 is a diagram of a structure of the glass-ceramic. As shown in FIG. 3, compression pressure layers 11 are disposed on surfaces of two opposite sides of the glass-ceramic 10, and the compression pressure layers 11 extend from the surfaces of the two sides of the glass-ceramic to the inside at a specific depth.

In an implementation of this application, the depth (denoted as DOL_0) of the compression pressure layer 11 is greater than or equal to 80 µm. DOL_0 is a depth at which a stress in the glass-ceramic changes from the compressive stress to the tensile stress, and is also a distance between a position at which a compressive stress value of the glass-ceramic is zero and the surface of the glass-ceramic. In some implementations, the depth of the compression pressure layer 11 is greater than or equal to 85 µm. In some other implementations, the depth of the compression pressure layer 11 is greater than or equal to 90 µm, and may be further greater than or equal to 95 µm. In some other implementations, the depth of the compression pressure layer 11 is greater than or equal to 100 µm, even greater than or equal to 130 µm, or the like. The depth of the compression pressure layer 11 is large. This may indicate that the strengthened glass-ceramic has better drop resistance, thereby better improving reliability of the electronic device.

In an implementation of this application, a compressive stress CS_50 of the glass-ceramic at a depth of 50 µm of the compression pressure layer is greater than or equal to 60 MPa. 50 µm is a depth value of the compression pressure layer calculated from the surface of the glass-ceramic, and CS_50 is a compressive stress value at a position that is 50 µm away from the surface of the glass-ceramic and that is inside the glass-ceramic. CS_50≥60 MPa can ensure that the glass-ceramic has high strength. A larger CS50 value indicates better drop resistance of the glass-ceramic. Specifically, in some implementations, CS_50 is greater than or equal to 90 MPa, and further is greater than or equal to 95 MPa. In some other implementations, CS_50 is greater than or equal to 100 MPa, and further is greater than or equal to 110 MPa. In another implementation, CS_50≥190 MPa.

In an implementation of this application, an absolute value |CT_AV| of an average tensile stress in the tensile stress layer (namely, an average tensile stress in the glass-ceramic) is greater than or equal to 35 MPa. Specifically, |CT_AV| may be greater than or equal to 45 MPa, greater than or equal to 50 MPa, greater than or equal to 55 MPa, greater than or equal to 60 MPa, greater than or equal to 80 MPa, or the like. Because the tensile stress is balanced with the compressive stress in the compression pressure layer, a large average tensile stress may also indicate good compressive stress performance, high strength, and good drop resistance of the glass-ceramic to some extent.

In an implementation of this application, a Knoop scratch threshold for lateral cracking of the glass-ceramic is greater than or equal to 2 N. A Knoop diamond indenter is used to perform a scratch test on the surface of the glass-ceramic. A scratch load corresponding to the start of a lateral crack is the Knoop scratch threshold for lateral cracking, and the threshold may be used to measure the scratch resistance of the glass-ceramic. A higher Knoop scratch threshold for lateral cracking indicates better scratch resistance of the glass-ceramic provided in this embodiment of this application.

In this implementation of this application, a 180-mesh silicon carbide sandpaper ground drop resistance test is performed on the glass-ceramic with a thickness of 0.65 mm on an entire device with weight of 200 g; and an average drop-resistant height of the glass-ceramic obtained through the test is greater than or equal to 1.0 m. A higher average drop-resistant height can more intuitively indicate excellent drop resistance of the glass-ceramic in this embodiment of this application. This can better improve reliability of the electronic device. The "entire device" is an electronic device model or a real electronic device with weight of 200 g that is assembled after the glass-ceramic in this embodiment of this application is processed into glass with a size required by the glass cover and is attached to a screen component.

Correspondingly, an embodiment of this application further provides a preparation method for the foregoing glass-ceramic, including:
(1) mixing, according to proportions of components in the glass-ceramic, raw materials corresponding to the components in the glass-ceramic, and performing melting, molding, and annealing treatment to obtain a glass base material, where the components in the glass-ceramic include SiO₂, Al₂O₃, MgO, ZnO, ZrO₂, Na₂O, Li₂O with a molar percentage of 0% to 9%, and K₂O with a molar percentage of 0% to 5%; and molar percentages of the components in the glass-ceramic satisfy: 0.11≤(Li₂O+Na₂O+K₂O)/(SiO₂+Al₂O₃)≤0.30, and Na₂O/(MgO+ZnO)≤0.9;
(2) sequentially performing nucleation treatment and crystallization treatment on the glass base material, so that the glass base material is crystallized to obtain a glass-ceramic material, where crystalline phases in the glass-ceramic material are a spinel crystalline phase and a ZrO₂ crystalline phase; and
(3) performing chemical strengthening treatment on the glass-ceramic material to obtain the glass-ceramic.

In the glass-ceramic provided in this embodiment of this application, crystallization is implemented by properly adjusting proportions of components in the glass base material, and combining nucleation treatment and crystallization treatment, to prepare the glass-ceramic whose crystalline phases are the spinel crystalline phase and the ZrO₂ crystalline phase. In addition, the glass-ceramic has an efficient ion exchange capability, and therefore can have both excellent drop resistance and scratch resistance.

Although the components in the foregoing glass-ceramic are represented based on oxides, in actual preparation, the raw materials corresponding to the components in the glass-ceramic may be various forms of materials available in the glass preparation field. For example, SiO₂ may be silica sand or the like; Al₂O₃ may be chaoite, aluminum oxide, aluminum hydroxide, or the like; Na₂O may be Na₂CO₃; MgO may be dolomite, basic magnesium carbonate, lightweight magnesium oxide, or the like; and ZnO may be ZnO, zinc silicate, or the like; and ZrO₂ may be ZrO₂, zirconium silicate, or the like. It only needs to be ensured that after proportions of these materials are converted into those of oxides, content requirements of the foregoing oxides can be satisfied.

In step (1), the melting is specifically melting the raw materials to form a glass liquid. A melting temperature may be 1400°C to 1700°C, for example, 1450°C, 1500°C, 1550°C, 1600°C, or 1650°C. The molding is a procedure of converting the glass liquid obtained through melting into a product with a geometric shape at a specific temperature. The molding method may include but is not limited to a casting method, a calendering method, a floating method, an overflow method, and a slit pull-up/pull-down method.

The annealing treatment usually needs to be performed after the molding, and the annealing treatment is to reduce or eliminate a thermal stress generated in the glass as much as possible. In an implementation of this application, an annealing temperature may be 350°C to 600°C, for example, 400°C, 450°C, 500°C, or 550°C.

In some implementations, the glass base material is plate-shaped/block-shaped, and a thickness of the glass base material may be specifically selected based on an application requirement. The components in the glass base material are basically the same as those of the foregoing to-be-strengthened glass-ceramic material, except that the glass base material herein does not include a crystalline phase. The components in the glass base material may be obtained through electron probe microanalysis or scanning electron microscopy combined with energy-dispersive X-ray spectroscopy (EDS, Energy Dispersive Spectrometer).

In this embodiment of this application, heat treatment is performed on the glass base material obtained in step (1), so that the glass base material can be crystallized, to generate an expected crystalline phase and glass phase. The heat treatment may be one-step heat treatment, or may be two-step heat treatment. In step (2) in this embodiment of this application, two-step heat treatment in which the nucleation treatment is performed before the crystallization treatment is used. A temperature of the crystallization treatment is higher than a temperature of the nucleation treatment. This is more conducive to steadily implementing crystallization. In the nucleation treatment, the glass may be fully nucleated. Then, the temperature is increased to a temperature near the crystallization temperature, and the temperature is kept for a specific time period (that is, the crystallization treatment), so that the crystal can grow up.

In some embodiments of this application, the temperature of the nucleation treatment may be 650°C to 800°C, and duration of the nucleation treatment is 0.5 h to 72 h; and the temperature of the crystallization treatment may be 700°C to 900°C, and duration of the crystallization treatment is 0.5 h to 48 h. Such a heat treatment process can better improve crystallinity of the glass-ceramic, and obtain the spinel crystalline phase and the ZrO₂ crystalline phase with a small particle size. Specifically, the temperature of the nucleation treatment may be 660°C, 680°C, 700°C, 710°C, 720°C, 730°C, 740°C, 750°C, 760°C, 790°C, or the like, and the duration of the nucleation treatment may be 0.5 h, 1 h, 1.5 h, 2 h, 3 h, 4 h, 5 h, 8 h, 10 h, 12 h, 15 h, 20 h, 24 h, 30 h, 36 h, 48 h, 60 h, or the like. The temperature of the crystallization treatment may be 710°C, 720°C, 730°C, 740°C, 750°C, 760°C, 780°C, 790°C, 800°C, 820°C, 850°C, 860°C, 870°C, 880°C, 890°C, or the like, and the duration of the crystallization treatment may be 0.5 h, 1 h, 1.5 h, 2 h, 3 h, 4 h, 5 h, 8 h, 10 h, 12 h, 15 h, 20 h, 24 h, 30 h, 36 h, 48 h, or the like.

In step (2), the glass base material obtained by crystallizing the glass base material basically maintains an original shape of the glass base material, and the glass base material is also plate-shaped/block-shaped. In some implementations of this application, before the chemical strengthening treatment in step (3) is performed on the glass-ceramic material, cold processing may be further performed on the glass-ceramic material to obtain a sheet-like glass-ceramic material or a glass-ceramic material in another expected shape. In this application, the glass-ceramic material before being chemically strengthened may be a 2D flat sheet, or may be a 2.5D sheet, a 3D sheet, or the like. This may be specifically adjusted based on an actual design requirement.

The chemical strengthening treatment procedure is essentially an ion exchange procedure. After the chemical strengthening treatment, a strengthened layer (namely, a compression pressure layer) with a specific depth is formed on a surface of the glass-ceramic, so that the glass-ceramic has a higher surface compressive stress, mechanical performance is further improved, surface hardness, fracture toughness, and other performance become better, and a capability of resisting an external force is greatly improved. For parameters such as DOL_0, CS_50, |CT_AV|, and a Knoop scratch threshold for lateral cracking of the glass-ceramic that are obtained after the chemical strengthening treatment, refer to the foregoing descriptions in this application. In addition, after chemical strengthening, light transmittance of the glass-ceramic is almost the same as that of the glass-ceramic material.

In an implementation of this application, in step (3), in the chemical strengthening treatment, the glass-ceramic material may be chemically strengthened by using a one-step ion exchange process or a multi-step (≥2 times) ion exchange process.

In some implementations of this application, the one-step ion exchange process is used in the chemical strengthening treatment. The one-step ion exchange process is to place the glass-ceramic material into a salt bath to perform one-step ion exchange. The salt bath used in the one-step ion exchange process may include a molten sodium salt, a molten potassium salt, or a molten sodium-potassium mixed salt. In this case, an appropriate ion exchange temperature may be 380°C to 550°C, for example, 400°C, 420°C, 450°C, 480°C, 500°C, or 520°C, and duration of the ion exchange may be 0.1 h to 72 h, for example, 2 h to 14 h. The salt bath may further include a specific amount of lithium salt, to adjust an ion exchange amount of the glass in the salt bath, so as to achieve good strengthening effect. Each of the molten sodium salt and the molten potassium salt may be corresponding nitrate, carbonate, sulfate, or the like. In some embodiments, the salt bath used in the one-step ion exchange process is specifically a pure molten KNO₃ salt, a pure molten NaNO₃ salt, or a mixed molten salt of KNO₃ and NaNO₃. In some embodiments, when the mixed molten salt is used, concentration of the molten NaNO₃ salt is 90 wt%, and concentration of the molten KNO₃ salt is 10 wt%.

In some other implementations of this application, a two-step ion exchange process is used in the chemical strengthening treatment. A first step of ion exchange is first chemical strengthening, and a second step of ion exchange is second time chemical strengthening. The first step of ion exchange is mainly Na⁺→Li⁺ exchange, and a used salt bath may include a molten NaNO₃ salt or a mixed molten salt of KNO₃ and NaNO₃. In some implementations, the salt bath used in the first step of ion exchange may further include a specific amount of lithium salt. The second step of ion exchange is mainly K⁺→Na⁺ exchange, and a used salt bath may include a molten KNO₃ salt or a mixed molten salt of KNO₃ and NaNO₃. A temperature of each step of ion exchange may independently range from 380°C to 550°C.

In some implementations of this application, before the chemical strengthening treatment, 3D hot bending treatment may be further performed on the sheet-like glass-ceramic material or the glass-ceramic material in the another expected shape. The 3D hot bending treatment may sequentially include a preheating procedure, a molding procedure, and an annealing cooling procedure. A temperature of the preheating procedure ranges from 0°C to 800°C. A temperature of the molding procedure ranges from 650°C to 900°C, and molding pressure ranges from 0 MPa to 2 MPa. A temperature of the annealing cooling procedure ranges from 0°C to 800°C. The molding pressure is pressure applied to a molding mold when the molding mold accommodating the glass-ceramic material is placed in a molding workstation.

In the 3D hot bending treatment procedure, the to-be-hot-bent glass-ceramic material may deform to some extent to obtain the 3D glass-ceramic material, and may be further crystallized to obtain to-be-strengthened 3D glass-ceramic with higher crystallinity. In this way, the 3D glass-ceramic obtained through the chemical strengthening treatment can have better drop resistance, and maintain good optical performance. In addition, 3D molding efficiency is improved, and a product yield of 3D molding is increased.

The foregoing preparation method for the glass-ceramic provided in this embodiment of this application has a simple process, and is suitable for industrial production.

The glass-ceramic provided in this embodiment of this application has good drop resistance, good scratch resistance, and excellent optical performance, and may be used in various electronic devices, to meet optical requirements for displaying and photographing of the electronic devices, and improve product reliability. Specifically, the electronic devices include but are not limited to a mobile phone, a tablet computer, a desktop computer, a notebook computer, a smart screen, a display device, a speaker, glasses, a watch, earphones, a vehicle-mounted product, and other electronic terminal devices related to mobile office, smart home, sports health, audio and video entertainment, and smart travel.

Embodiments of this application are further described below by using a plurality of embodiments.

### Embodiment 1

Components in a glass base material that are listed in Table 1 are prepared, evenly mixed by using a mixer, and then added to a platinum crucible. The platinum crucible is placed into a high-temperature lifting furnace, a temperature is increased to 1650°C, and the components are molten at 1650°C for 10 hours to obtain a glass liquid that is homogenized and fully clarified. The glass liquid is cast into a molding mold for molding. After the temperature is reduced to 900°C, the molding mold is placed into an annealing furnace for annealing at 500°C, to obtain a block-shaped glass base material. The glass base material is transparent and colorless, and does not contain a crystalline phase.

The foregoing obtained glass base material is placed into a crystallization furnace, and nucleation treatment and crystallization treatment are sequentially performed according to nucleation and crystallization treatment processes listed in Table 1, to obtain a glass-ceramic material including a crystalline phase.

Cutting, CNC processing, coarse grinding, and polishing treatment are performed on the glass-ceramic material based on an expected shape and a size requirement, to obtain a to-be-chemically-strengthened glass-ceramic material. According to a chemical strengthening process shown in Table 1, the glass-ceramic material in the required shape is placed into a crucible containing a molten salt bath for chemical strengthening, to obtain the glass-ceramic.

According to the method shown in Embodiment 1, glass-ceramic in Embodiment 2 to Embodiment 4 is prepared based on conditions shown in Table 1, and glass in comparative examples is prepared based on conditions shown in Table 2. Other parameters are basically the same as those in Embodiment 1. In Embodiment 2, 3D hot bending treatment is further performed before chemical strengthening treatment. Specifically, a sheet-like glass-ceramic material obtained in Embodiment 2 is placed into a molding mold, and then placed in a hot bending device; and preheating, molding, and cooling procedures are performed to obtain 3D glass-ceramic. Six workstations are set for the preheating procedure, and temperatures of the workstations are respectively 690°C, 710°C, 730°C, 750°C, 770°C, and 790°C in sequence. Three workstations are set for the molding procedure, temperatures of the workstations are respectively 820°C, 840°C, and 840°C in sequence, and pressure of the workstations is respectively 0.8 MPa, 0.8 MPa, and 0.5 MPa. Three workstations are set for the cooling procedure, and temperatures of the workstations are respectively 650°C, 600°C, and 500°C in sequence.

Crystal types, crystal contents, average grain sizes, densities, Young's moduli, shear moduli, and optical performance of the glass-ceramic prepared in all embodiments are tested, and stress performance, Knoop scratch performance, and drop resistance of the glass-ceramic are also tested. Related results are summarized in Table 1. Related tests are also performed on glass products in the comparative examples, and test results are summarized in Table 2.

The crystal types, the crystal contents, and the average grain sizes of the glass-ceramic are tested by using an X-ray diffractometer (XRD). Specifically, after a glass-ceramic sample is ground into fine powder, the XRD device (specifically, Shimadzu XRD-6100) is used for testing. During the test, a diffraction angle 20 ranges from 10° to 80°, a scanning speed is 6°/min, an operating voltage is 40 kV, and an operating current is 30 mA. An XRD pattern obtained in the test is analyzed by using professional processing software, and is compared with a standard phase PDF card to determine a crystal type. Content of each crystalline phase in the glass-ceramic can be calculated by performing Rietveld refinement on XRD test result data. A diffraction peak in the obtained XRD pattern is calculated according to a Scherrer formula D=Kλ/(βcosθ) (λ is an X-ray wavelength, β is a full width at half maximum, and K=0.89), to obtain an average grain size of the corresponding crystal.

The Young's modulus and the shear modulus of the glass are tested by using an ultrasonic method. Specifically, the glass sample is placed on a transverse wave probe of an ultrasonic material presentation system (specifically, a device whose model is UMS-100 of TECLAB Limited), to collect a transverse wave signal; and then is switched to a longitudinal wave probe to collect a longitudinal wave signal. A thickness and a density of the test sample are input, and values of the Young's modulus and the shear modulus can be calculated by using compute software in the system.

Optical performance such as haze, |b value|, and 550 nm transmittance of the glass is measured by using a professional optical test instrument, for example, a Konica Minolta spectrophotometer CM-3600A and a Shimadzu ultraviolet-visible spectrophotometer UV-2600.

The stress performance such as CS_50, DOL_0, and |CT_AV| of the strengthened glass is tested by using a stress meter. Specifically, a refractive liquid is dripped on a test channel of a stress test device, then the to-be-tested glass sample is placed on the test channel, a thickness, a refractive index, and a photoelastic coefficient of the to-be-tested sample are input, and then a test start button is touched to obtain related stress performance such as CS_50, DOL_0, and |CT_AV|. The stress test device used in this embodiment of this application is a stress meter SLP-2000 of Japan Orihara Industrial Co., Ltd., and a wavelength of a light source is 596 nm.

The Knoop scratch threshold for lateral cracking and a maximum scratch (including scraps) width are obtained by performing a scratch test on the glass sample by using a Knoop indenter.

Specifically, a test procedure for the Knoop scratch threshold for lateral cracking is as follows: A Knoop diamond indenter on a tester (in this embodiment of this application, an Anton Paar nano indentation tester SA-STEP700-NHT³-MCT is used, and a model of the Knoop diamond indenter is K-B02) gradually increases a pressing load on a surface of the glass sample from zero, and the scratch test is performed on the glass surface, where a movement rate of the indenter is 5 mm/min, a pressure loading rate of the indenter is 10 N/min, and a scratch length is fixed at 2.5 mm. A pressing load value that is of the indenter and that corresponds to a case in which a lateral crack starts to appear in a scratch (as shown in FIG. 4) is recorded, that is, the Knoop scratch threshold for lateral cracking is obtained. A plurality of values may be averaged after a plurality of scratch tests, to improve accuracy of the test data. In addition, if transverse plastic deformation starts to occur in the scratch, but no crack appears, it is not considered that the lateral crack occurs.

A test of the maximum scratch (including scraps) width is as follows: After the scratch test is performed on the glass sample according to the foregoing method, a maximum value of a scratch width of an overall scratch is measured by using an optical microscope. If a lateral crack is generated in the scratch, and lateral cracking scraps appear, as shown in FIG. 5, the maximum value of the scratch width is a maximum width including the scraps.

The drop resistance of the glass sample may be measured based on a sandpaper ground drop-resistant height. Specifically, the strengthened glass is processed into glass with a size required by a glass cover of a mobile phone, and is attached to a screen component, to be assembled into an entire electronic device model or an entire real electronic device with weight of about 200 g. 180-mesh silicon carbide sandpaper is placed on the ground (simulating the rough ground), a glass screen of the mobile phone drops in parallel to the sandpaper ground, and a failure height of the glass cover is recorded. An average value is calculated after a plurality of tests, to obtain an average value of drop-resistant heights.

**Table 1**

| | | Embodiment 1 | Embodiment 2 | Embodiment 3 | Embodiment 4 |
|---|---|---|---|---|---|
| Component/ mol% | SiO₂ | 46.0 | 45.0 | 40.5 | 38.0 |
| | Al₂O₃ | 26.0 | 27.0 | 28.0 | 26.0 |
| | B₂O₃ | 1.0 | 0.5 | 6.0 | 9.0 |
| | Li₂O | 3.0 | 5.0 | / | / |
| | Na₂O | 5.0 | 6.5 | 9.0 | 9.0 |
| | K₂O | / | / | 0.5 | 3.0 |
| | MgO | 6.0 | 5.0 | 5.0 | 5.0 |
| | ZnO | 10.0 | 9.0 | 9.0 | 8.0 |
| | ZrO₂ | 3.0 | 2.0 | 2.0 | 2.0 |
| (Li₂O+Na₂O+K₂O)/ (SiO₂+Al₂O₃) | | 0.11 | 0.16 | 0.14 | 0.19 |
| Na₂O/(MgO+ZnO) | | 0.31 | 0.46 | 0.64 | 0.69 |
| Nucleation treatment | | 730°C for 5 h | 710°C for 6 h | 700°C for 4 h | 740°C for 5 h |
| Crystallization treatment | | 790°C for 3 h | 770°C for 4 h | 800°C for 3 h | 780°C for 4 h |
| Salt bath for first strengthening/wt% | | 100% NaNO₃ | 90% NaNO₃+10% KNO₃ | 100% KNO₃ | 100% KNO₃ |
| First strengthening process | | 450°C for 2 h | 450°C for 2.5 h | 480°C for 10 h | 480°C for 14 h |
| Salt bath for second strengthening/wt% | | / | 100 wt% KNO₃ | / | / |
| Second strengthening process | | / | 450°C for 0.3 h | / | / |
| Crystalline phase characteristics | Crystalline phase components | Spinel crystalline phase (primary)+ZrO₂ crystalline phase (secondary) | Spinel crystalline phase (primary)+ZrO₂ crystalline phase (secondary) | Spinel crystalline phase (primary)+ZrO₂ crystalline phase (secondary) | Spinel crystalline phase (primary)+ZrO₂ crystalline phase (secondary) |
| | Average grain size/nm | 35 | 39 | 41 | 30 |
| | Primary crystalline phase content/wt% | 32.46 | 25.33 | 34.39 | 38.38 |
| | Secondary crystalline phase content/wt% | 4.80 | 3.12 | 2.78 | 3.01 |
| | Total crystalline phase content/wt% | 37.26 | 28.45 | 37.17 | 41.39 |
| Glass density/g·cm⁻³ | | 2.96 | 2.92 | 2.89 | 2.88 |
| Young's modulus/GPa | | 109.3 | 105.6 | 95.5 | 97.4 |
| Shear modulus/GPa | | 44.1 | 42.9 | 39.5 | 37.9 |
| Optical performance | Haze/% | 0.15 | 0.13 | 0.21 | 0.14 |
| | \|b value\| in Lab color space | 0.54 | 0.67 | 0.78 | 0.71 |
| | Transmittance at a wavelength of 550 nm/% | 90.9 | 90.8 | 89.9 | 90.2 |
| Stress performance | CS_50/MPa | 105 | 113 | 194 | 104 |
| | DOL_0/µm | 145 | 138 | 105 | 93 |
| | \|CT_AV\|/MPa | 55 | 62 | 80 | 47 |
| Knoop scratch performance | Knoop scratch threshold for lateral cracking/N | 4.3 | 3.8 | 2.3 | 3.1 |
| | Maximum scratch (including scraps) width/µm | 72.9 | 109.3 | > 140.0 | 119.1 |
| Drop resistance | Average value of sandpaper ground drop-resistant heights/m | ≥1.5 | ≥1.5 | ≥1.5 | ≥1.1 |

**Table 2**

| | | Comparative example 1 | Comparative example 2 | Comparative example 3 | Comparative example 4 |
|---|---|---|---|---|---|
| Component/ mol% | SiO₂ | 64.0 | 69.0 | 66.0 | 37.0 |
| | Al₂O₃ | 12.0 | 11.0 | 6.0 | 26.0 |
| | B₂O₃ | / | / | 1.5 | 11.0 |
| | P₂O₅ | / | / | 0.5 | / |
| | Li₂O | 10.0 | 8.0 | 20.0 | |
| | Na₂O | 6.5 | 5.0 | 5.0 | 12.0 |
| | K₂O | 2.0 | 2.0 | / | 2.0 |
| | MgO | 4.5 | 5.0 | / | 4.0 |
| | ZnO | / | / | / | 7.0 |
| | ZrO₂ | 1.0 | / | 1.0 | 1.0 |
| (Li₂O+Na₂O+K₂O)/ (SiO₂+Al₂O₃) | | 0.24 | 0.19 | 0.35 | 0.22 |
| Na₂O/(MgO+ZnO) | | 1.44 | 1.0 | / | 1.09 |
| Nucleation treatment | | / | / | 550°C for 4 h | 720°C for 5 h |
| Crystallization treatment | | / | / | 660°C for 4 h | 770°C for 4 h |
| Salt bath for first strengthening/wt% | | 100% NaNO₃ | 100% NaNO₃ | 30% NaNO₃+70% KNO₃ | 100% KNO₃ |
| First strengthening process | | 410°C for 2.5 h | 430°C for 4 h | 470°C for 8 h | 490°C for 8 h |
| Salt bath for second strengthening/wt% | | 99% KN0₃+1% NaNO₃ | 100 wt% KNO₃ | / | / |
| Second strengthening process | | 440°C for 1 h | 430°C for 0.6 h | / | / |
| Precipitation of a primary crystalline phase | Crystal components | / | / | Lithium disilicate (primary)+petalite (secondary) | Spinel crystalline phase (primary)+ZrO₂ crystalline phase (secondary) |
| | Average grain size/nm | / | / | 30 | 33 |
| | Primary crystalline phase content/wt% | / | / | 49.57 | 26.47 |
| | Secondary crystalline phase content/wt% | / | / | 40.52 | 1.34 |
| | Total crystalline phase content/wt% | / | / | 90.09 | 27.81 |
| Glass density/g·cm⁻³ | | 2.49 | 2.42 | 2.46 | 2.93 |
| Young's modulus/GPa | | 85.9 | 83.8 | 99.2 | 94.8 |
| Shear modulus/GPa | | 36.0 | 33.7 | 40.5 | 38.2 |
| Optical performance | Haze/% | 0.06 | 0.04 | 0.13 | 0.19 |
| | \|b value\| in Lab color space | 0.12 | 0.11 | 0.53 | 0.69 |
| | Transmittance at a wavelength of 550 nm/% | 91.2 | 91.4 | 90.8 | 90.5 |
| Stress performance | CS_50/MPa | 72 | 124 | 110 | 178 |
| | DOL_0/µm | 139 | 130 | 130 | 94 |
| | \|CT_AV\|/MPa | 49 | 58 | 59 | 74 |
| Knoop scratch performance | Knoop scratch threshold for lateral cracking/N | >5 | 0.6 | 0.5 | 1.6 |
| | Maximum scratch (including scraps) width/µm | 14.7 | ≥140.0 | 106.5 | > 140.0 |
| Drop resistance | Average value of sandpaper ground drop-resistant heights/m | ≥0.8 | ≥1.0 | ≥1.5 | ≥1.3 |

It can be learned from Table 1 that, after the nucleation treatment and the crystallization treatment are performed on the glass base material in each of Embodiments 1 to 4, the primary spinel crystalline phase and the secondary ZrO₂ crystalline phase are precipitated. In addition, the glass still has excellent optical performance, the transmittance to the light with the wavelength of 550 nm is greater than or equal to 89%, the |b value| in Lab color space is less than or equal to 2.0 (specifically, less than or equal to 0.9), and the haze is less than or equal to 0.25%. Through comparison with Comparative examples 1 and 2 in Table 2, the optical performance of the glass-ceramic obtained after crystallization in Embodiments 1 to 4 is basically equivalent to that of the crystal-free glass in Comparative examples 1 and 2.

The spinel crystal has a strong ionic bond, and hardness of the crystal is high (Mohs hardness reaches 8). This can effectively improve mechanical performance of the glass, such as drop resistance and scratch resistance. The Young's modulus of the glass-ceramic including the spinel crystal in each of Embodiments 3 and 4 reaches at least 95 GPa, and the Young's modulus of the glass-ceramic in each of Embodiments 1 and 2 reaches at least 100 GPa. Therefore, intrinsic structure strength is significantly improved. In addition, in the chemically strengthened glass-ceramic in Embodiment 4, DOL_0≥90 µm, CS_50≥100 MPa, and |CT_AV|≥45 MPa. When the thickness is 0.65 mm, a 180-mesh silicon carbide sandpaper ground drop resistance test is performed on the entire device with the weight of 200 g, and the average drop-resistant height is greater than or equal to 1.1 m. However, in the chemically strengthened glass-ceramic in Embodiments 1 to 3, DOL_0≥100 µm, CS_50≥105 MPa, |CT_AV|≥55 MPa, and the average drop-resistant height is greater than or equal to 1.5 m. In terms of Knoop scratch performance, the Knoop scratch threshold for lateral cracking in each of Embodiments 1 to 4 is greater than or equal to 2 N, and the Knoop scratch threshold for lateral cracking in each of Embodiments 1 and 2 is greater than or equal to 3.5 N. However, in Table 2, although the Knoop scratch threshold for lateral cracking of the crystal-free glass in Comparative example 1 is greater than 5 N, the average drop-resistant height of the glass is greater than or equal to 0.8 m, and the drop resistance of the glass is far poorer than that of the glass in Embodiments 1 to 4. The crystal-free glass in Comparative example 1 presents a "soft" characteristic due to the weak structure strength and the low Young's modulus. When the glass is scratched by a sharp hard object, as a scratching force increases, the "soft" glass tends to first plastically deform to absorb scratching energy, and then crack laterally. In terms of macroscopic performance, the "soft" glass tends to produce fine scratches with a small width instead of coarse scratches with a severe lateral crack. Therefore, the maximum scratch width in Comparative example 1 is smaller. However, as the surface compressive stress increases, a surface status also changes from "soft" to "hard", and the lateral cracking tendency increases. As shown in Comparative example 2, the glass has the low Knoop scratch threshold for lateral cracking and the large maximum scratch width. In terms of drop resistance, the glass in Comparative examples 1 and 2 has no crystal, and has weak structure strength, resulting in significantly reduced cracking resistance and a small drop-resistant height of the glass in the drop procedure.

Not limited to theory, the crystalline phase in the glass can effectively improve intrinsic structure strength of the glass, and improve a capability of the glass to resist penetration of a sharp hard object, and the cracking resistance. In Table 2, the lithium disilicate and petalite crystals are precipitated from the glass-ceramic in Comparative example 3, and can resist crack propagation generated in the drop procedure. Therefore, the drop resistance and the cracking resistance of the glass-ceramic are significantly higher than those in Comparative examples 1 and 2; and the average drop-resistant height is greater than or equal to 1.5 m, and is equivalent to those in Embodiments 1 to 3. However, in the glass-ceramic in Comparative example 3, the Knoop scratch threshold for lateral cracking is only 0.5 N, and the scratch resistance is significantly weaker than that in Embodiments 1 to 4. Both hardness and Young's moduli of the lithium disilicate and petalite crystals are lower than those of the spinel crystal.

Although spinel and ZrO₂ crystals are also precipitated from the glass-ceramic in Comparative example 4 in Table 2, the Young's modulus of the glass-ceramic in Comparative example 4 is only 94.8 GPa due to all the glass components and the network structure (for example, Na₂O/(MgO+ZnO)>1), the average drop-resistant height is greater than or equal to 1.3 m, and the drop resistance is also excellent. However, the Knoop scratch threshold for lateral cracking is 1.6 N, and the scratch resistance is slightly poorer than that in Embodiments 1 to 5. Therefore, the glass-ceramic in Comparative example 4 cannot have both good scratch resistance and good drop resistance.

The foregoing descriptions are merely example implementations of this application, and descriptions thereof are specific and detailed, but cannot be understood as a limitation on the patent scope patent of this application. It should be noted that a person of ordinary skill in the art may make some variants and improvements without departing from the concept of this application and the variants and improvements shall fall within the protection scope of this application.

It should be understood that "first", "second", and various numbers in this specification are merely used for differentiation for ease of description, but are not intended to limit the scope of this application. In this application, both "greater than or equal to (≥) "and "less than or equal to (≤)" include this number. A character "/" generally indicates an "or" relationship between associated objects.

## Claims

1. Glass-ceramic, wherein crystalline phases in the glass-ceramic are a spinel crystalline phase and a ZrO₂ crystalline phase; the glass-ceramic comprises SiO₂, Al₂O₃, MgO, ZnO, ZrO₂, Na₂O, Li₂O with a molar percentage of 0% to 9%, and K₂O with a molar percentage of 0% to 5%; and molar percentages of components in the glass-ceramic satisfy: 0.11≤(Li₂O+Na₂O+K₂O)/(SiO₂+Al₂O₃)≤0.30, and Na₂O/(MgO+ZnO)≤0.9.

2. The glass-ceramic according to claim 1, wherein 0.25≤Na₂O/(MgO+ZnO)≤0.9.

3. The glass-ceramic according to claim 1 or 2, wherein 0.11≤(Li₂O+Na₂O+K₂O)/(SiO₂+Al₂O₃)≤0.25.

4. The glass-ceramic according to any one of claims 1 to 3, wherein the glass-ceramic comprises the following components in molar percentages:
SiO₂: 32% to 56%;
Al₂O₃: 15% to 35%;
MgO: 3% to 10%;
ZnO: 3% to 15%;
ZrO₂: 0.1% to 6%;
Na₂O: 0.1% to 12%;
Li₂O: 0% to 9%;
K₂O: 0% to 5%; and
B₂O₃: 0% to 10%.

5. The glass-ceramic according to any one of claims 1 to 4, wherein the spinel crystalline phase comprises (MgₓZn₁₋ₓ)Al₂O₄, or comprises MgAl₂O₄ and ZnAl₂O₄, or comprises (MgₓZn₁₋ₓ)Al₂O₄, MgAl₂O₄, and ZnAl₂O₄, wherein 0<x<1.

6. The glass-ceramic according to any one of claims 1 to 5, wherein a mass percentage of the spinel crystalline phase in the glass-ceramic is greater than that of the ZrO₂ crystalline phase.

7. The glass-ceramic according to any one of claims 1 to 6, wherein a sum of mass percentages of the spinel crystalline phase and the ZrO₂ crystalline phase in the 3D glass-ceramic is 5% to 90%.

8. The glass-ceramic according to any one of claims 1 to 7, wherein in the glass-ceramic, a ratio of the mass percentage of the spinel crystalline phase to the mass percentage of the ZrO₂ crystalline phase is (4 to 14):1.

9. The glass-ceramic according to any one of claims 1 to 8, wherein both an average grain size of the spinel crystalline phase and an average grain size of the ZrO₂ crystalline phase are less than or equal to 60 nm.

10. The glass-ceramic according to any one of claims 1 to 9, wherein the glass-ceramic comprises 2D glass-ceramic, 2.5D glass-ceramic, or 3D glass-ceramic.

11. The glass-ceramic according to any one of claims 1 to 10, wherein when a thickness of the glass-ceramic is less than or equal to 0.7 mm, transmittance of the glass-ceramic to light with a wavelength of 550 nm is greater than or equal to 88%; a b value in Lab color space satisfies: |b value|≤2.0; and haze is less than or equal to 0.25%.

12. The glass-ceramic according to any one of claims 1 to 11, wherein a compression pressure layer is formed on a surface of the glass-ceramic, and there is a tensile stress layer inside the glass-ceramic.

13. The glass-ceramic according to claim 12, wherein a depth of the compression pressure layer is greater than or equal to 80 µm.

14. The glass-ceramic according to claim 12 or 13, wherein a compressive stress CS_50 of the glass-ceramic at a depth of 50 µm of the compression pressure layer is greater than or equal to 60 MPa.

15. The glass-ceramic according to any one of claims 12 to 14, wherein an absolute value |CT_AV| of an average tensile stress in the tensile stress layer is greater than or equal to 35 MPa.

16. The glass-ceramic according to any one of claims 1 to 15, wherein a Young's modulus of the glass-ceramic is greater than or equal to 95 GPa.

17. The glass-ceramic according to any one of claims 1 to 16, wherein a Knoop scratch threshold for lateral cracking of the glass-ceramic is greater than or equal to 2 N.

18. The glass-ceramic according to any one of claims 1 to 17, wherein a 180-mesh silicon carbide sandpaper ground drop resistance test is performed on the glass-ceramic with a thickness of 0.65 mm on an entire device with weight of 200 g; and an average drop-resistant height of the glass-ceramic obtained through the test is greater than or equal to 1.0 m.

19. A preparation method for glass-ceramic, comprising:
mixing, according to proportions of components in the glass-ceramic, raw materials corresponding to the components in the glass-ceramic, and performing melting, molding, and annealing treatment to obtain a glass base material, wherein the components in the glass-ceramic comprise SiO₂, Al₂O₃, MgO, ZnO, ZrO₂, Na₂O, Li₂O with a molar percentage of 0% to 9%, and K₂O with a molar percentage of 0% to 5%; and molar percentages of the components in the glass-ceramic satisfy: 0.11≤(Li₂O+Na₂O+K₂O)/(SiO₂+Al₂O₃)≤0.30, and Na₂O/(MgO+ZnO)≤0.9;
sequentially performing nucleation treatment and crystallization treatment on the glass base material, so that the glass base material is crystallized to obtain a glass-ceramic material, wherein crystalline phases in the glass-ceramic are a spinel crystalline phase and a ZrO₂ crystalline phase; and
performing chemical strengthening treatment on the glass-ceramic to obtain the glass-ceramic.

20. The preparation method according to claim 19, wherein a temperature of the crystallization treatment is higher than a temperature of the nucleation treatment; the temperature of the nucleation treatment is 650°C to 800°C, and duration of the nucleation treatment is 0.5 h to 72 h; and the temperature of the crystallization treatment is 700°C to 900°C, and duration of the crystallization treatment is 0.5 h to 48 h.

21. A glass cover, wherein the glass cover is made of the glass-ceramic according to any one of claims 1 to 18, or is made of the glass-ceramic prepared by using the preparation method for the glass-ceramic according to claim 19 or 20.

22. An electronic device, comprising a housing assembled on an outer side of the electronic device and a circuit board located inside the housing, wherein the housing is made of glass, and the glass comprises the glass-ceramic according to any one of claims 1 to 18, or the glass-ceramic prepared by using the preparation method for the glass-ceramic according to claim 19 or 20.

23. The electronic device according to claim 22, wherein the housing comprises a display cover assembled on a front side of the electronic device, and the display cover comprises the glass.

24. The electronic device according to claim 22 or 23, wherein the housing comprises a rear cover assembled on a rear side of the electronic device, and the rear cover is made of the glass.

25. The electronic device according to any one of claims 22 to 24, wherein the electronic device further comprises a camera component located inside the housing, the housing comprises a camera protection cover, the camera protection cover covers the camera component, and the camera protection cover is made of the glass.
